(19) **Europäisches Patentamt European Patent Office Office européen des brevets**

(11) **EP 1 681 671 B1**

(12) **EUROPEAN PATENT SPECIFICATION**

(45) Date of publication and mention of the grant of the patent:
**22.10.2008 Bulletin 2008/43**

(51) Int Cl.:
*G10L 19/14* (2006.01)          *G10L 19/00* (2006.01)
*G10L 21/02* (2006.01)

(21) Application number: **06250140.8**

(22) Date of filing: **12.01.2006**

(54) **Scalable audio data arithmetic decoding method, medium, and apparatus**

Skalierbares arithmetisches Audiodatendekodierverfahren, Medium und Vorrichtung

Procédé, support et appareil de décodage arithmétique de données audio extensibles

(84) Designated Contracting States:
**AT BE BG CH CY CZ DE DK EE ES FI FR GB GR HU IE IS IT LI LT LU LV MC NL PL PT RO SE SI SK TR**

(30) Priority: **12.01.2005 US 643118 P**
**13.04.2005 US 670643 P**
**21.04.2005 US 673363 P**
**18.11.2005 KR 2005110878**

(43) Date of publication of application:
**19.07.2006 Bulletin 2006/29**

(73) Proprietor: **Samsung Electronics Co., Ltd.**
**Yeongtong-gu**
**Suwon-si, Gyeonggi-do (KR)**

(72) Inventors:
• **Kim, Junghoe**
**Seoul (KR)**
• **Oh, Eunmi**
**Bundang-gu**
**Seongnam-si**
**Gyeonggi-do (KR)**
• **Son, Changyong**
**217-1401 Chungmu Apt.**
**Gunpo-si**
**Gyeonggido (KR)**

• **Choo, Kihyun**
**105-202 Woosung 1-cha Apt.**
**Seoul (KR)**

(74) Representative: **Greene, Simon Kenneth**
**Elkington and Fife LLP**
**Prospect House**
**8 Pembroke Road**
**Sevenoaks,**
**Kent TN13 1XR (GB)**

(56) References cited:
**GB-A- 2 280 816          US-A1- 2003 187 634**

• **RONGSHAN YU ET AL: "Advanced Audio Zip ? A Scalable Perceptual and Lossless Audio Codec" ISO/IEC JTC1/SC29/WG11 M9134, XX, XX, December 2002 (2002-12), page complete, XP002392328**
• **EUNMI OH ET AL: "Improvement of coding efficiency in MPEG-4 audio scalable lossless coding (SLS)" ISO/IEC JTC1/SC29/WG11 MPEG2003/M10414, XX, XX, December 2003 (2003-12), pages 1-11, XP002392326**

**Description**

BACKGROUND OF THE INVENTION

Embodiments of the present invention relate to scalable audio data decoding, and more particularly, to a scalable audio data arithmetic decoding method, medium, and apparatus, and a method, medium, and apparatus truncating an audio data bitstream.

Audio lossless encoding techniques have been required for audio broadcasting and/or archiving purposes. Major technologies for lossless audio encoding include application of an entropy encoder using time/frequency transformation or linear prediction, for example.

When scalability through bitstream re-parsing is applied, for example, a bitstream corresponding to a frame is truncated at an arbitrary position, at a server end, and transmitted to a decoding end.

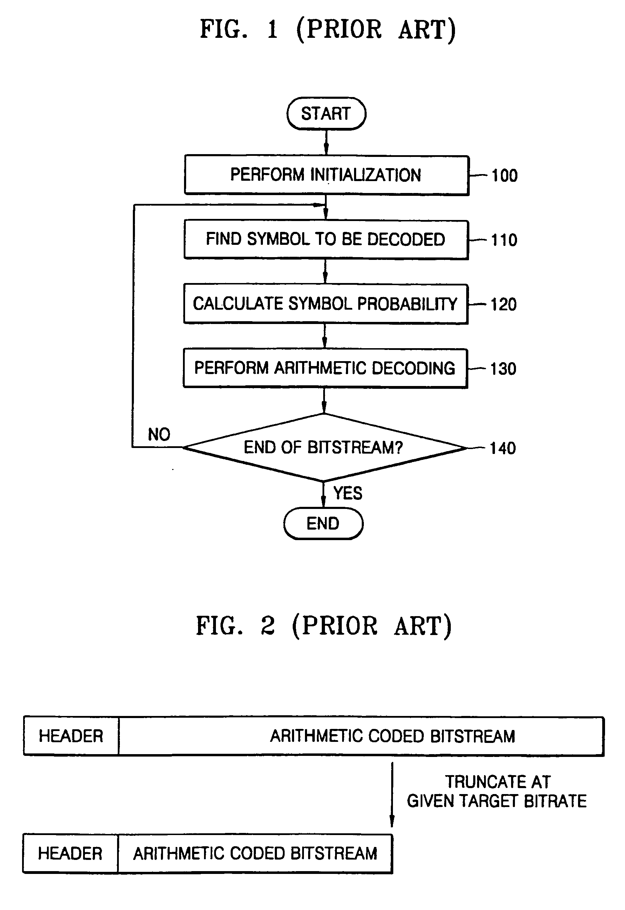

FIG. 1 illustrates a conventional arithmetic decoding method.

First, initialization is performed, in operation 100, and a symbol desired to be decoded is detected, in operation 110. By using the corresponding context, the probability of the existence of the symbol can be calculated, in operation 120, and arithmetic decoding can then be performed, in operation 130. Whether the symbol is the end of the bitstream can then be checked, in operation 140, and if the symbol is not the end of the bitstream, a symbol to be decoded can again be determined and the above operations may be repeated. The decoding is finished when the symbol is determined to be the end of the bitstream.

Meanwhile, when an arithmetic decoding method is performed, all of the symbols to be decoded are known, or a predetermined termination code is inserted, and the decoder is informed of the time when the decoding should be finished. However, when a bitstream is truncated, as shown in FIG. 2, this information, indicating the termination code, is cut off and the decoder cannot know when to finish the decoding. Thus, since the accurate termination time is not known, data that is not desired may be decoded.

GB 2,280,816 teaches an encoder and a decoder which uses markers in the bit stream to indicate the end of decoding.

SUMMARY OF THE INVENTION

An aspect of the present invention includes a scalable data arithmetic decoding method for decoding a scalable arithmetic coded symbol as defined in claim 1.

The determining of whether to continue decoding includes calculating K, assuming that K is a right-hand side value of a following equation:

$$v2 < \frac{(high - low + 1) \cdot freq}{2^{14}} - v1 + low - 1$$

$$v2 \geq \frac{(high - low + 1) \cdot freq}{2^{14}} - v1 + low - 1$$

This may further include determining, according to a value of K, whether to continue the decoding, where in these equations, v1 denotes a value of the valid bitstream remaining after truncation, v2 denotes a value of the truncated bitstream after the truncation, dummy denotes a number of v2 bits, freq denotes the probability value for the symbol, high and low denote an upper limit and a lower limit, respectively, of a range in which the probability value exists, decoding the symbol as 1 if K is equal to or greater than $2^{dummy}-1$, and decoding the symbol as 0 if K is equal to or less than 0, and determining that the ambiguity occurs, if K is between 0 and $2^{dummy}-1$, and correspondingly terminating the decoding.

Before the arithmetic decoding of the symbol, the method may include finding the symbol, and calculating the probability for the symbol.

The calculation of the probability for the symbol may include finding a decoding mode from header information of a bitstream to be decoded, and obtaining the probability for the symbol by referring to a context of the symbol if the decoding mode is a context-based arithmetic coding mode (cbac).

In the arithmetic decoding of the symbol, if a first non-zero sample on a bitplane is decoded, a sign bit corresponding to the sample may be arithmetic decoded, and in the determining that the ambiguity occurs, if K is between 0 and $2^{dummy}-1$, the ambiguity may have been determined to have occurred, and the decoding may be terminated by setting a sample, decoded immediately before the ambiguity, to 0.

The calculation of the probability for the symbol may include finding a decoding mode from header information of a bitstream to be decoded, and if the decoding mode is a bitplane Golomb mode (bpgc), obtaining the probability for the symbol, assuming that the data to be decoded has a Laplacian distribution.

In the arithmetic decoding of the symbol, if a first non-zero sample on a bitplane is decoded, a sign bit corresponding to the sample may be arithmetically decoded, and, in the determining that the ambiguity occurs, if K is between 0 and $2^{dummy}-1$, the ambiguity may be determined to have occurred, and the decoding is terminated with setting a sample, decoded immediately before the ambiguity, to 0.

The calculation of the probability for the symbol may further include finding a decoding mode from header information of a bitstream to be decoded, and if the decoding mode is a low energy mode, obtaining the probability for the symbol by using probability model information of the bitstream header.

Another aspect of the present invention includes a scalable data arithmetic decoding apparatus to decode a scalable arithmetic coded symbol as defined in claim 9.

The apparatus may further include a symbol determination/probability prediction unit to find the symbol and to calculate the probability for the symbol.

Another aspect of the present invention includes a medium including computer readable code as defined in claim 11.

Additional aspects and/or advantages of the invention will be set forth in part in the description which follows and, in part, will be apparent from the description, or may be learned by practice of the invention.

BRIEF DESCRIPTION OF THE DRAWINGS

These and/or other aspects and advantages of the invention will become apparent and more readily appreciated from the following description of the embodiments, taken in conjunction with the accompanying drawings of which:

FIG. 1 illustrates a conventional arithmetic decoding method;
FIG. 2 illustrates bitstream truncation for ordinary scalability;
FIG 3 illustrates a pseudo code for conventional binary arithmetic decoding;
FIG. 4 illustrates a value input in a buffer, near a truncation point, when a bitstream is truncated;
FIG. 5 illustrates an arithmetic decoding apparatus for scalable audio data, according to an embodiment of the present invention;
FIG 6 illustrates an ambiguity checking unit, such as for the arithmetic decoding apparatus of FIG.5, according to an embodiment of the present invention;
FIG. 7 illustrates arithmetic decoding of scalable audio data, according to an embodiment of the present invention;
FIG. 8 illustrates additional decoding applying a determining of whether to continue to restore a scalable bitstream, according to an embodiment of the present invention;
FIG. 9 illustrates processing of an ambiguity occurring in a sign bit, according to an embodiment of the present invention; and
FIG. 10 illustrates truncating of a bitstream of scalable audio data, according to an embodiment of the present invention.

DETAILED DESCRIPTION OF THE PREFERRED EMBODIMENTS

Reference will be made in detail to embodiments of the present invention, examples of which are illustrated in the accompanying drawings, wherein like reference numerals refer to the like elements throughout. Embodiments are described below to explain the present invention by referring to the figures.

Accordingly, a scalable audio data arithmetic decoding method, medium, and apparatus, and a method, medium, and apparatus truncating an audio data bitstream according to embodiments of the present invention will now be described in greater detail.

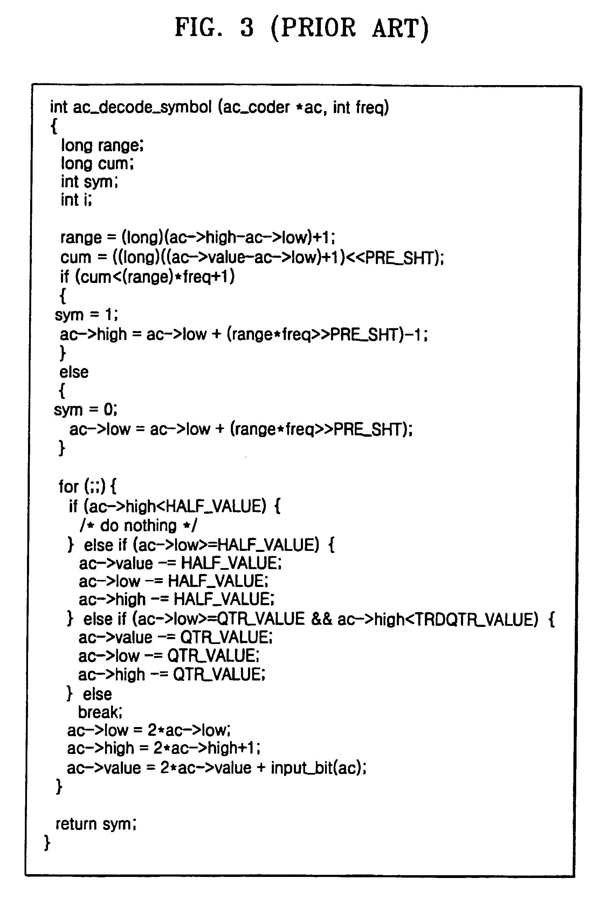

FIG. 3 illustrates a pseudo code for conventional binary arithmetic decoding. This is an arithmetic decoding algorithm that may be used in an entropy coder of MPEG-4 scalable lossless audio coding.

According to the pseudo code shown in FIG. 3, a decoded symbol is determined by current values of frequency, low, high, and value and then rescaling and updating of values of low, high, and value are performed.

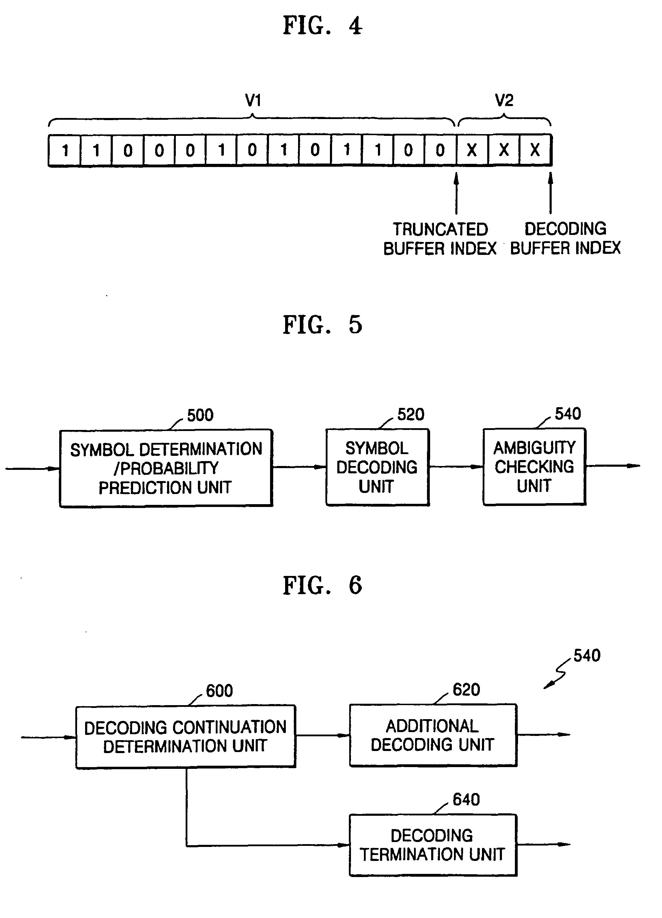

FIG. 4 illustrates a value input to a buffer, near a truncation point, when a bitstream is truncated. Since there is no more meaningful information after a truncated buffer index, the input value is meaningless. Here, this value is referred to as v2 and the value in the remaining part of the buffer is referred to as v1.

According to an embodiment of the present invention, there are 3 bits (dummy bits) in v2, e.g., the value v2 accordingly ranging from 0 to 7.

FIG. 5 illustrates an arithmetic decoding apparatus for scalable audio data, according to an embodiment of the present invention.

The arithmetic decoding apparatus may include a symbol decoding unit 520 and an ambiguity checking unit 540. The arithmetic decoding apparatus may further, for example, include a symbol determination/probability prediction unit 500.

The symbol determination/probability prediction unit 500 identifies a symbol to be decoded in a bitstream and predicts the probability of the existence of the symbol.

Performing the probability prediction of the existence symbol will now be explained. First, from the header information of the bitstream to be decoded, a decoding mode may be detected. If the decoding mode is a context-based arithmetic coding (cbac) mode, as referred to by the context of the symbol to be decoded, the probability of the symbol may be obtained. If the decoding mode is a bitplane Golomb coding mode, the probability of the symbol to be decoded may be obtained by assuming that the data to be decoded has a Laplacian distribution. Also, if the decoding mode is a low energy mode, the probability of the existence of the symbol to be decoded is obtained by using the probability model information of the bitstream header.

The symbol decoding unit 520 may perform arithmetic decoding of the symbol by using the predicted probability and may then generate the symbol. Decoding of the sign bit on a bitplane will now be explained. In decoding of an MPEG-4 scalable lossless bitstream, a first non-zero sample among values on the bitplane may be decoded, and then, the sign corresponding to the sample may be decoded. However, if an ambiguity error occurs in the sign value and the decoding is immediately terminated because of the occurrence of the ambiguity error, the sign of the non-zero sample that is decoded immediately before cannot be known. For this reason, when the decoding is terminated in the sign bit, the sample decoded immediately before is set to 0 and the decoding is terminated.

Assuming that the right-hand side value of the below Equations 1 and 2 is K, the ambiguity checking unit 540 may calculate K, and according to the value of K, determine whether to continue to decode a symbol:

$$v2 \; < \; \frac{(\text{high} - \text{low} + 1) \cdot \text{freq}}{2^{14}} - v1 + \text{low} - 1 \qquad \ldots\ldots(1)$$

$$v2 \; \geq \; \frac{(\text{high} - \text{low} + 1) \cdot \text{freq}}{2^{14}} - v1 + \text{low} - 1 \qquad \ldots\ldots(2)$$

Here, $v1$ denotes the value of the valid bitstream remaining after truncation, $v2$ denotes the value of the truncated bitstream after the truncation, *dummy* denotes the number of $v2$ bits, *freq* denotes the probability value of the symbol, *high* and low denote the upper limit and lower limit of a range in which the probability value of the symbol exists. [Study on 14496-4: 2001/PDAM 5, Scalable Lossless Coding (SLS), ISO/IEC JTC 1/SC 29/WG 11 N6792]

Equations 1 and 2 will now be explained in greater detail. A decoding expression of the pseudo code shown in FIG. 3 may be divided into v1 and v2 and then expanded.

If $(v1 + v2 - low + 1) \cdot 2^{14} < (high - low + 1) \cdot freq$, the symbol (sym) may be generated as having the value of 1. Here, if this is rearranged in relation to v2, Equation 1 is obtained.

Also, if $(v1 + v2 - low + 1) \cdot 2^{14} \geq (high - low + 1) \cdot freq$, the symbol (sym) may be generated as having the value of 0. Here, if this is rearranged in relation to v2, Equation 2 is obtained.

In equation 1, if the value of the right-hand side expression is greater than 7, the symbol may be decoded as 1, regardless of v2. In Equation 2, if the value of the right-hand side expression is less than 0, the symbol may be decoded as 0, regardless of v2. In other cases, a decoding ambiguity occurs and the decoding is finished.

FIG. 6 illustrates an ambiguity checking unit 540, such as for the arithmetic decoding apparatus of FIG. 5, according to an embodiment of the present invention. The ambiguity checking unit 540 may include a decoding continuation determination unit 600, an additional decoding unit 620, and a decoding termination unit 640, for example.

Assuming that the right-hand side value of Equations 1 and 2 is K, the decoding continuation determination unit 600 may calculate the value of K, and according to value of K, determine whether or not to continue to decode a symbol. The additional decoding unit 620 may decode the symbol as 1 if K is equal to or greater than $2^{\text{dummy}}-1$, and if K is equal to or less than 0, decode the symbol as 0. If K is between 0 and $2^{\text{dummy}}-1$, the decoding termination unit 640 may determine that an ambiguity has occurred, and terminate the decoding.

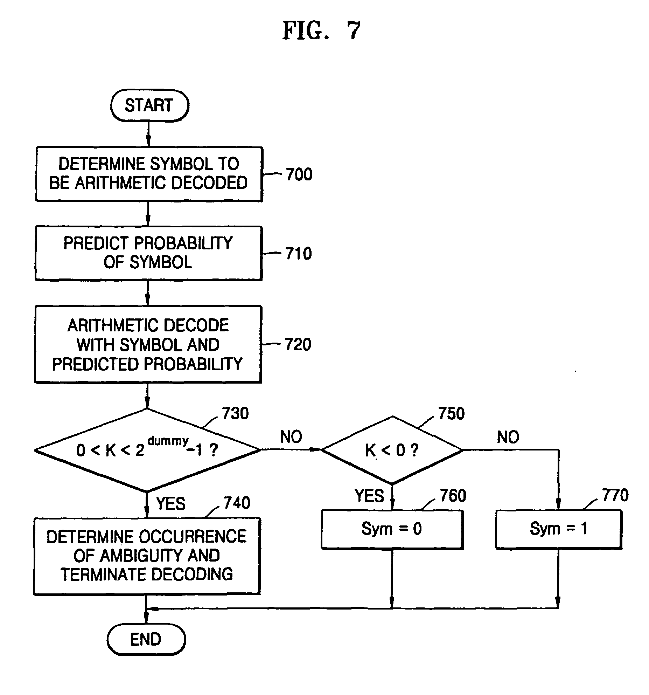

FIG. 7 illustrates an arithmetic decoding of scalable audio data, according to an embodiment of the present invention, and referring to FIG. 7, a determining of whether to continue restoration of a scalable bitstream, according to an embodiment the present invention will now be explained in greater detail.

A symbol to be decoded in an arithmetic coded scalable bitstream may be determined, in operation 700, and the probability of the determined symbol may be predicted, in operation 710.

Performing the probability prediction of the symbol will now be further explained.

From the header information of the bitstream to be decoded, a decoding mode may be determined. If the decoding mode is a context-based arithmetic coding (cbac) mode, e.g., by referring to the context of the symbol to be decoded, the probability of the existence of the symbol may be obtained. If the decoding mode is a bitplane Golomb coding mode, the probability of the symbol to be decoded may be obtained by assuming that the data to be decoded has a Laplacian distribution. Also, if the decoding mode is a low energy mode, the probability of the existence of the symbol to be decoded may be obtained by using the probability model information of the bitstream header.

By using the predicted probability, the symbol may be arithmetically decoded and generated, in operation 720.

Assuming that the right-hand side value of equations 1 and 2 is K, when K is calculated, if K found to be between 0 and $2^{dummy}-1$, in operation 730, it may be determined that an ambiguity has occurred, and the arithmetic decoding may be determined, in operation 740.

If K is found to be equal to or less than 0, in operation 750, the symbol may be decoded as 0, in operation 760, and if K found to be is equal to or greater than $2^{dummy}-1$, the symbol may be decoded as 1, in operation 770.

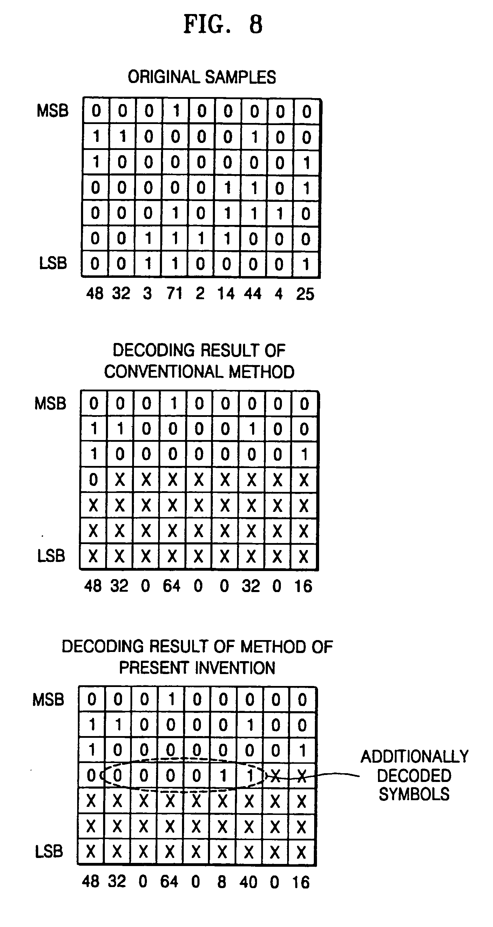

FIG. 8 illustrates an additional decoding determining whether to continue to restore a scalable bitstream, according to an embodiment of the present invention. FIG. 8 illustrates 5 samples being additionally decoded.

In the MPEG-4 scalable lossless decoding, a first non-zero sample among values on the bitplane is decoded, then the sign corresponding to the sample is decoded. However, if an ambiguity error occurs in the sign value, and the decoding is immediately terminated because of the occurrence of the ambiguity error, the sign of the non-zero sample that is decoded immediately before cannot be known. For this reason, when the decoding is terminated in the sign bit, the sample decoded immediately before is set to 0 and the decoding is terminated.

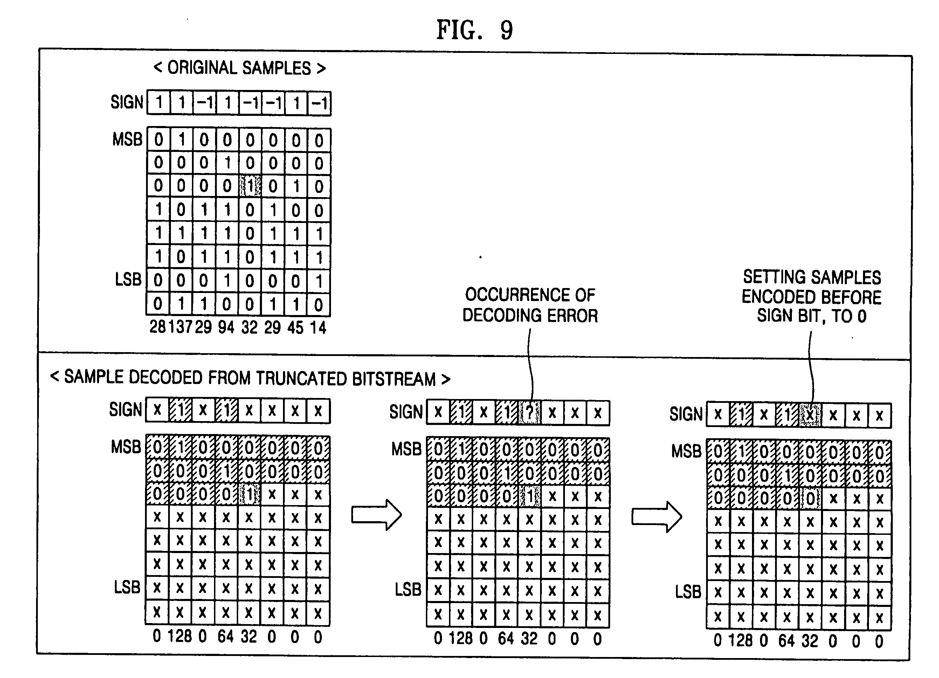

FIG. 9 illustrates a processing of an ambiguity occurring in a sign bit, according to an embodiment of the present invention.

First, the pseudo code for arithmetic decoding for each of BPGC, CBAC and low energy modes will now be explained in greater detail. Here, *ambiguity_check(f)* is a function to detect ambiguity for the arithmetic decoding, with the argument f indicating a probability of 1. The function *terminate_decoding()* is a function to terminate decoding of LLE data when an ambiguity occurs. The function *smart_decoding_cbac_bpgc()* is a function to decode additional symbols in the absence of incoming bits in cbac/bpgc mode decoding. A scalable audio data arithmetic decoding, according to an embodiment of the present invention, continues up to the point where no ambiguity exists. This code (the pseudo code) includes the above functions, *ambiguity_check(f)* and *terminate_decoding()*. In addition, the function *smart_decoding_low_energy()* is a function to decode additional symbols in the absence of incoming bits in the low energy mode. This also includes the functions, *ambiguity_check(f)* and *terminate_decoding(),* see below:

```
while ((max_bp[g][sfb] cur_bp[g][sfb]<LAZY_BP) && (cur_bp[g][sfb] >= 0)){
 for (g=0;g<num_windows_group;g++)}
  for (sfb = 0;sfb<num_sfb;sfb++){
   if ((cur_bp[g][sfb]>=0) && (lazy_bp[g][sfb] > 0)){
    width = swb_offset[g][sfb+1 swb-offset[g][sfb];
    for (win=0;win<window_group_len[g];win++){
     for (bin=0;bin<width;bin++){
       if (!is_Ile_ics_eof ()){
          if (interval[g][win][sfb][bin] > res[g][win][sfb][bin] +
(1<<cur_bp[g][sfb])
             {
              freq = determine_frequency():
              res[g][win][sfb][bin] += decode(freq) << cur_bp[g][sfb];
                 /* decode bit-plane cur_bp*/
              if ((!is_sig[g][win][sfb][bin]) && (res[g][win][sfb][bin])) {
                 /* decode sign bit of res if necessary */
                 res[g][win][sfb][bin] *= (decode(freq_sign))? 1:-1;
                 is_sig[g][win][sfb][bin] = 1;
                       }
                 }
           }
       }
       else {
         smart_decoding_cbac_bpgc();
       }
             }
```

```
                    }
                cur_bp[g][sfb]--; /* progress to next bit-plane */
                }
            }
        }
    }

    /* low energy mode decoding */
    for (g = 0;g < num_windows_group; g++){
    for (sfb = 0; sfb <num_sfb+num_osf_sfb;sfb++){
      if ((cur_bp[g][sfb] >= 0) && (Iazy_bp[g][sfb] <= 0))
        {
        width = swb_offset[g][sfb+1] swb_offset[g][sfb];
          for (win=0;win<window_group_len[g];win++){
           res[g][sfb][win][bin] = 0;
            pos = 0;
            for (bin=0;bin<width;bin++){
             if (!is_ile_ics_eof ()){
                /* decoding of binary string and reconstructing res */
                while (decode(freq_silence[pos])==1) {
               res[g][sfb][win][bin] ++;
                  pos++;
                  if (pos>2) pos = 2;
                  if (res[g][sfb][win][bin]==(1<<(max_bp[g][sfb]+1))-1) break;
                }
                /* decoding of sign of res */
                if (!is_sig[g][win][sfb][bin]) && res[g][sfb][win][bin]){
                  res[g][sfb][win][bin] *= (decode(freq_sign))? -1:1;
                  is_sig[g][win][sfb][bin] = 1;
                }
             }
           }
            else smart_ decoding_low energy();
        }
      }
    }
   }
  }
```

An arithmetic decoding of the truncated SLS bitstream, according to an embodiment of the present invention, provides an efficient method for decoding an intermediate layer corresponding to a given target bitrate, such that, even when there are no bits input to the decoding buffer, meaningful information is still included in the decoding buffer. The decoding process is performed up to the point where no ambiguity exists in the symbol. The following pseudo code shows an algorithm for detecting an ambiguity in an arithmetic decoding module, according to an embodiment of the present invention. A variable *num_dummy_bits* indicates the number of bits not input to a value buffer because of truncation.

```
    int ambiguity_check(int freq)

  {
    /* if there is no ambiguity, returns 1 */
    /* otherwise, retuns 0 */
    upper = 1<<num_dummy_bits;
    decisionVal = ((high-low)*freq>>PRE_SHT)-value+low-1;
    if(decisionVal>upper II decisionVal<0) return 0;
    else return 1;
  }
```

Below, *smart_decoding_cbac_bpgc()* or *smart_decoding_low_energy()* may be performed when *num_dummy_bits* is greater than 0. In order to prevent sign bit errors, the spectral value of the current spectral line is set to be zero when an ambiguity can occur while decoding a sign bit. All index variables in the arithmetic decoding process according to an embodiment of the present invention are carried over from the previous arithmetic decoding process.

```
smart_decoding_cbac_bpgc()

{
 /* BPGC/CBAC normal decoding with ambiguity detection */
 while ((max_bp[g][sfb] - cur_bp[g][sfb]<LAZY_BP) && (cur_bp[g][sfb] >= 0)){
  for (;g<num_windows_group;g++){
   for (;sfb<num_sfb;sfb++){
    if ((cur_bp[g][sfb]>=0) && (lazy_bp[g][sfb] > 0)){
      width = swb_offset[g][sfb+1] - swb_offset[g][sfb];
      for (;win<window_group_len[g] ;win++){
       for (;bin<width;bin++){
         if (interval[g][win][sfb][bin] > res[g][win][sfb][bin] + (1<<cur_bp[g][sfb])
            {
                freq = determine_frequency();
                if (ambiguity_check(freq)) {
                /* no ambiguity for arithmetic decoding */
                res[g][win][sfb][bin] += decode(freq ) << cur_bp[g][sfb];
                        /* decode bit-plane cur_bp*/
                if ((!is_sig[g][win][sfb][bin]) && (res[g][win][sfb][bin] )) {
                /* decode sign bit of res if necessary */
                if (ambiguity_check(freq) {
                res[g][win][sfb][bin] *= (decode(freq_sign))? 1:-1;
                is-sig[g][win][sfb][bin] = 1;
                                 }
                else {
          /* discard the decoded symbol prior to sign symbol */
          res[g][win][sfb][bin] = 0;
             terminate_decoding();
                            }
                    }
                }
                else terminate_decoding();
                }
            }
         }
       cur_bp[g][sfb]--; /* progress to next bit-plane */
     }
    }
   }
  }
}


smart decoding low energy()

{
 /* low energy mode decoding */
 for (;g < num_windows_group; g++){
  for (; sfb <num_sfb+num_osf_sfb;sfb++){
   if ((cur_bp[g][sfb] >= 0) && (lazy_bp[g][sfb] <= 0))
    {
      width = swb_offset[g][sfb+1] swb_offset[g][sfb];
      for (;win<window_group_len[g];win++){
       res[g][sfb][win][bin] = 0;
        pos = 0;
       for (;bin<width;bin++){
      while (1){
        /* if ambiguity check is false, discard the spectrum is set to be 0 */
        if(!ambiguity_check(freq)) res[g][sfb][win][bin] = 0, terminate_decoding();
            tmp = decode(freq_silence[pos]);
            if(tmp==0) break;
            res[g][sfb][win][bin] ++;
            pos++;
            if (pos>2) pos = 2;
```

```
        if (res[g][sfb][win][bin]==(1<<(max_bp[g][sfb]+1))-1) break;
    }
    /* decoding of sign of res */
  if (!is_sig[g][win][sfb][bin]) && res[g][sfb][win][bin]){
    /* if ambiguity check is false, the current spectrum value is set to be 0 */
    if(!ambiguity_check(freq)) res[g][sfb][win][bin] = 0, terminate_decoding();
      res[g][sfb][win][bin] *= (decode(freq_sign))? - -1:1;
      is_sig[g][win][sfb][bin] = 1;
      }
    }
   }
  }
 }
```

Below, the process of re-parsing and bitstream truncation, when the size of a bitstream is transmitted in the header, according to a method of generating a truncated bitstream by re-parsing will now be explained.

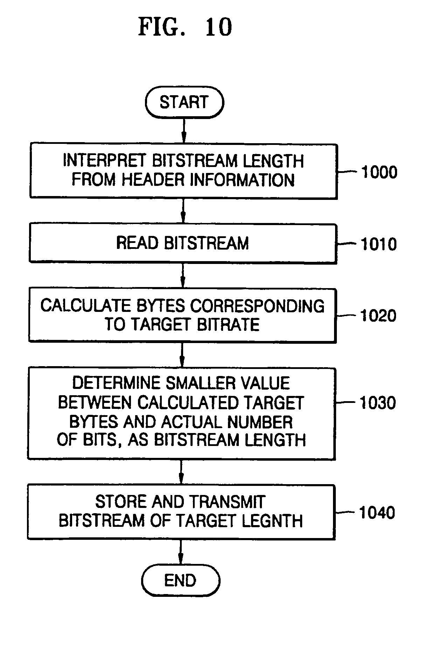

FIG. 10 illustrates a truncating of a bitstream of scalable audio data, according to an embodiment of the present invention. Referring to FIG. 10, the method of truncating a bitstream of the scalable audio data will now be explained in greater detail.

From the bitstream header information, the length of the bitstream may be parsed, in operation 1000. By using the following equations 3 and 4, bytes corresponding to a target bitrate may be calculated, in operation 1020. The target bitrate may be provided from the outside, for example, by a server or a user.

$$\text{target\_bits} = (int)(\text{target\_bitrate}/2*1024.*osf/\text{sampling\_rate}+0.5)-16 \ \dots\dots(3)$$

$$\text{target\_bytes} = (\text{target\_bits}+7)/8 \ \dots\dots(4)$$

With the obtained target byte, the bitstream length can be modified. That is, a smaller value between the actual number of bits and the *target_bytes* is determined as the length of the bitstream, in operation 1030. A bitstream of the target length may also be stored and transmitted, in operation 1040.

The method of re-parsing and truncating the bitstream will now be explained in more detail. The SLS bitstream can be truncated in a given target bitrate in a simple way. The modification of the values of *lle_ics_length* does not affect LLE decoding results before the truncation point. The *lle_ics_length* is independent from an LLE decoding procedure. The bitstream truncation will now be explained. The LLE bitstream is read from the bitstream. The available frame length at a given target bitrate is calculated. The simplest way to calculate the available frame length is by using the above Equations 3 and 4.

Here, in Equations 3 and 4, the variable *target_bitrate* represents the target bitrate in bits/sec, the variable osf represents an oversampling factor, and the variable *sampling_rate* represents the sampling frequency of the input audio signal in Hz. By taking a smaller value of the available frame length and the current frame length, *lie_ics_length* may be updated as follows:

$$\text{lle\_ics\_length} = min(\text{lle\_ics\_length}, \text{target\_bytes}).$$

The truncated bitstream with the updated ile_ics_length can be generated.

Embodiments of the present invention can also be embodied as computer readable code in/on a medium, e.g., on a computer readable recording medium. The medium may be any data storage device that can store/transmit data which can be thereafter be read by a computer system. Examples of the media may include read-only memory (ROM), random-access memory (RAM), CD-ROMs, magnetic tapes, floppy disks, and optical data storage devices, noting that these are only examples.

Thus, according to a scalable audio data arithmetic decoding method, medium, and apparatus of the above described embodiments of the present invention, data to which scalability is applied when arithmetic coding is performed in MPEG-4 scalable lossless audio coding can be efficiently decoded. Even when a bitstream is truncated, a decoding termination point can be known such that additional decoding of the truncated part can be performed.

Although a few embodiments of the present invention have been shown and described, it would be appreciated by those skilled in the art that changes may be made in these embodiments without departing from the principles of the invention, the scope of which is defined in the claims.

## Claims

1. A scalable data arithmetic decoding method for decoding a scalable arithmetic coded symbol, the method comprising:

   arithmetic decoding a desired symbol by using the symbol and a probability for the symbol; and
   determining whether to continue a decoding of the symbol;

   whereby, in determining whether to continue the decoding, the method includes:

   decoding using dummy bits in order to decode the bitstream remaining after truncation if a valid bitstream remains;
   continuing the decoding if the symbol is decoded without ambiguity regardless of the dummy bits; and
   terminating decoding if the symbol is decoded relying on the dummy bits, and it is determined that the ambiguity occurs.

2. The method of claim 1, wherein the determining of whether to continue decoding comprises:

   calculating K, where K is a right-hand side value of a following equation:

$$v2 \; < \; \frac{(\mathrm{high} - \mathrm{low} + 1) \cdot \mathrm{freq}}{2^{14}} - v1 + \mathrm{low} - 1$$

$$v2 \; \geq \; \frac{(\mathrm{high} - \mathrm{low} + 1) \cdot \mathrm{freq}}{2^{14}} - v1 + \mathrm{low} - 1$$

   determining, according to a value of K, whether to continue the decoding, where in these equations, v1 denotes a value of the valid bitstream remaining after truncation, v2 denotes a value of the truncated bitstream after the truncation, dummy denotes a number of v2 bits, freq denotes the probability value for the symbol, high and low denote an upper limit and a lower limit, respectively, of a range in which the probability value exists;
   decoding the symbol as 1 if K is equal to or greater than $2^{\mathrm{dummy}} - 1$, and decoding the symbol as 0 if K is equal to or less than 0; and
   determining that the ambiguity occurs, if K is between 0 and $2^{\mathrm{dummy}} - 1$, and correspondingly terminating the decoding.

3. The method of claim 2, before the arithmetic decoding of the symbol, further comprising:

   finding the symbol; and
   calculating the probability for the symbol.

4. The method of claim 3, wherein the calculation of the probability for the symbol comprises:

   finding a decoding mode from header information of a bitstream to be decoded; and
   obtaining the probability for the symbol by referring to a context of the symbol if the decoding mode is a context-based arithmetic coding mode (cbac).

5. The method of claim 4, wherein, in the arithmetic decoding of the symbol, if a first non-zero sample on a bitplane is decoded, a sign bit corresponding to the sample is arithmetic decoded, and
   in the determining that the ambiguity occurs, if K is between 0 and $2^{\mathrm{dummy}} - 1$, the ambiguity is determined to have occurred, and the decoding is terminated by setting a sample, decoded immediately before the ambiguity, to 0.

6. The method of claim 3, wherein the calculation of the probability for the symbol comprises:

finding a decoding mode from header information of a bitstream to be decoded; and
if the decoding mode is a bitplane Golomb mode (bpgc), obtaining the probability for the symbol, assuming that the data to be decoded has a Laplacian distribution.

7. The method of claim 3, wherein, in the arithmetic decoding of the symbol, if a first non-zero sample on a bitplane is decoded, a sign bit corresponding to the sample is arithmetically decoded, and wherein, in the determining that the ambiguity occurs, if K is between 0 and $2^{dummy}$-1, the ambiguity is determined to have occurred, and the decoding is terminated with setting a sample, decoded immediately before the ambiguity, to 0.

8. The method of claim 3, wherein the calculation of the probability for the symbol comprises:

finding a decoding mode from header information of a bitstream to be decoded; and
if the decoding mode is a low energy mode, obtaining the probability for the symbol by using probability model information of the bitstream header.

9. A scalable data arithmetic decoding apparatus to decode a scalable arithmetic coded symbol, the apparatus comprising:

a symbol decoding unit arranged to arithmetic decode a desired symbol by using the symbol and a probability for the symbol; and
an ambiguity checking unit arranged to determine whether to continue a decoding by checking for an ambiguity, the ambiguity checking unit comprising a decoding continuation determination unit to calculate K, assuming that K is a right-hand side value of a following equation, and according to a value of K, determining whether to continue decoding:

$$v2 \; < \; \frac{(high-low+1) \cdot freq}{2^{14}} - v1 + low - 1 \; ,$$

$$v2 \; \geq \; \frac{(high-low+1) \cdot freq}{2^{14}} - v1 + low - 1 \; ,$$

wherein v1 denotes a value of a valid bitstream remaining after truncation, v2 denotes a value of a truncated bitstream after the truncation, *dummy* denotes a number of v2 bits, *freq* denotes the probability value for the symbol, *high* and low denote an upper limit and lower limit, respectively, of a range in which the probability value exists;
an additional decoding unit arranged to decode the symbol as 1 if K is equal to or greater than $2^{dummy}$-1, and to decode the symbol as 0 if K is equal to or less than 0; and
a decoding termination unit arranged to determine that the ambiguity occurs if K is between 0 and $2^{dummy}$-1 , and to correspondingly terminate the decoding.

10. The apparatus of claim 9, further comprising a symbol determination/probability prediction unit arranged to find the symbol and to calculate the probability for the symbol.

11. A medium comprising computer readable code adapted to implement all the steps of any one method of claims 1 thorough 8.

**Patentansprüche**

1. Skalierbares arithmetisches Datendekodierverfahren zum Dekodieren eines skalierbaren arithmetischen kodierten Symbols, wobei das Verfahren umfasst:

   arithmetisches Dekodieren eines gewünschten Symbols unter Verwendung des Symbols und einer Wahrscheinlichkeit für das Symbol und
   Bestimmen, ob eine Dekodierung des Symbols fortzusetzen ist,

   wobei beim Bestimmen, ob die Dekodierung fortzusetzen ist, das Verfahren beinhaltet:

   Dekodierung unter Verwendung von Dummy-Bits, um den Bitstrom zu dekodieren, der nach einer Trunkierung verbleibt, wenn ein gültiger Bitstrom verbleibt,
   Fortsetzen des Dekodierens, wenn das Symbol eindeutig dekodiert ist, ungeachtet der Dummy-Bits, und
   Beenden des Dekodierens, wenn das Symbol gestützt auf die Dummy-Bits dekodiert ist, und bestimmt ist, dass die Mehrdeutigkeit auftritt.

2. Verfahren nach Anspruch 1, wobei das Bestimmen, ob eine Dekodierung fortzusetzen ist, umfasst:

   Berechnen von K, wobei K ein Wert auf der rechten Seite einer folgenden Gleichung ist:

$$v2 \prec \frac{(hoch - niedrig + 1) \cdot freq}{2^{14}} - v1 + niedrig - 1$$

$$v2 \geq \frac{(hoch - niedrig + 1) \cdot freq}{2^{14}} - v1 + niedrig - 1$$

   gemäß einem Wert von K Bestimmen, ob das Dekodieren fortzusetzen ist, wobei in diesen Gleichungen v1 einen Wert eines gültigen Bitstroms bezeichnet, der nach einer Trunkierung verbleibt, v2 einen Wert eines trunkierten Bitstroms nach der Trunkierung bezeichnet, Dummy eine Anzahl von v2-Bits bezeichnet, freq den Wahrscheinlichkeitswert für das Symbol bezeichnet, hoch und niedrig einen oberen Grenzwert bzw. einen unteren Grenzwert eines Bereichs bezeichnet, in dem der Wahrscheinlichkeitswert vorliegt,
   Dekodieren des Symbols als 1, wenn K gleich oder größer ist als $2^{dummy}-1$ und Dekodieren des Symbols als 0, wenn K gleich oder kleiner ist als 0, und
   Bestimmen, dass die Mehrdeutigkeit auftritt, wenn K zwischen 0 und $2^{dummy}-1$ liegt, und dementsprechend Beenden der Dekodierung.

3. Verfahren nach Anspruch 2, das vor dem arithmetischen Dekodieren des Symbols ferner umfasst:

   Finden des Symbols und
   Berechnen der Wahrscheinlichkeit für das Symbol.

4. Verfahren nach Anspruch 3, wobei das Berechnen der Wahrscheinlichkeit für das Symbol umfasst:

   Finden eines Dekodiermodus aus Headerinformation eines zu dekodierenden Bitstroms und
   Ermitteln der Wahrscheinlichkeit für das Symbol durch Rückgriff auf einen Kontext des Symbols, wenn der Dekodiermodus ein kontextbasierter arithmetischer Kodiermodus (cbac) ist.

5. Verfahren nach Anspruch 4, wobei beim arithmetischen Dekodieren des Symbols, wenn eine erste nicht Null betragende Abtastung auf einer Bitebene dekodiert wird, ein zur Abtastung korrespondierendes Vorzeichenbit arithmetisch dekodiert wird, und
   wobei beim Bestimmen, dass die Mehrdeutigkeit auftritt, wenn K zwischen 0 und $2^{dummy}-1$ liegt, bestimmt wird, dass die Mehrdeutigkeit aufgetreten ist, und wobei das Dekodieren **dadurch** beendet wird, dass eine Abtastung, die unmittelbar vor der Mehrdeutigkeit dekodiert worden ist, auf 0 gesetzt wird.

**6.** Verfahren nach Anspruch 3, wobei das Berechnen der Wahrscheinlichkeit für das Symbol umfasst:

Finden eines Dekodiermodus aus Headerinformation eines zu dekodierenden Bitstroms und
wenn der Dekodiermodus ein Bitebenen-Golomb-Modus (bpgc) ist, Ermitteln der Wahrscheinlichkeit für das Symbol unter der Annahme, dass die zu dekodierenden Daten eine Laplace-Verteilung aufweisen.

**7.** Verfahren nach Anspruch 3, wobei beim arithmetischen Dekodieren des Symbols, wenn eine erste nicht Null betragende Abtastung auf einer Bitebene dekodiert wird, ein zur Abtastung korrespondierendes Vorzeichenbit arithmetisch dekodiert wird, und
wobei beim Bestimmen, dass die Mehrdeutigkeit auftritt, wenn K zwischen 0 und $2^{dummy}$-1 liegt, bestimmt wird, dass die Mehrdeutigkeit aufgetreten ist, und wobei das Dekodieren **dadurch** beendet wird, dass eine Abtastung, die unmittelbar vor der Mehrdeutigkeit dekodiert worden ist, auf 0 gesetzt wird.

**8.** Verfahren nach Anspruch 3, wobei das Berechnen der Wahrscheinlichkeit für das Symbol umfasst:

Finden eines Dekodiermodus aus Headerinformation eines zu dekodierenden Bitstroms und
wenn der Dekodiermodus ein Niedrigenergiemodus ist, Ermitteln der Wahrscheinlichkeit für das Symbol unter Verwendung von Wahrscheinlichkeitsmodellinformation des Bitstromheaders.

**9.** Skalierbare arithmetische Datendekodiervorrichtung zum Dekodieren eines skalierbaren arithmetischen kodierten Symbols, wobei die Vorrichtung umfasst:

eine Symboldekodiereinheit, die so ausgebildet ist, dass sie ein gewünschtes Symbol unter Verwendung des Symbols und einer Wahrscheinlichkeit für das Symbol arithmetisch dekodiert, und
eine Mehrdeutigkeitsprüfeinheit, die so ausgebildet ist, dass sie durch Prüfen auf eine Mehrdeutigkeit bestimmt, ob eine Dekodierung fortzusetzen ist, wobei die Mehrdeutigkeitsprüfeinheit eine Dekodierungsfortsetzungsbestimmungseinheit zum Berechnen von K umfasst, unter der Annahme, dass K ein Wert auf der rechten Seite einer folgenden Gleichung ist, und gemäß einem Wert von K bestimmt wird, ob die Dekodierung fortzusetzen ist:

$$v2 \prec \frac{(hoch - niedrig + 1) \cdot freq}{2^{14}} - v1 + niedrig - 1$$

$$v2 \geq \frac{(hoch - niedrig + 1) \cdot freq}{2^{14}} - v1 + niedrig - 1$$

wobei v1 einen Wert eines gültigen Bitstroms bezeichnet, der nach einer Trunkierung verbleibt, v2 einen Wert eines trunkierten Bitstroms nach der Trunkierung bezeichnet, Dummy eine Anzahl von v2-Bits bezeichnet, freq den Wahrscheinlichkeitswert für das Symbol bezeichnet, hoch und niedrig einen oberen Grenzwert bzw. einen unteren Grenzwert eines Bereichs bezeichnet, in dem der Wahrscheinlichkeitswert vorliegt, eine zusätzliche Dekodiereinheit, die so ausgebildet ist, dass sie das Symbol als 1 dekodiert, wenn K gleich oder größer ist als $2^{dummy}$-1, und das Symbol als 0 dekodiert, wenn K gleich oder kleiner ist als 0, und eine Dekodierbeendigungseinheit, die so ausgebildet ist, dass sie bestimmt, dass die Mehrdeutigkeit auftritt, wenn K zwischen 0 und $2^{dummy}$-1 liegt, und dementsprechend das Dekodieren beendet.

**10.** Vorrichtung nach Anspruch 9, ferner umfassend eine Symbolbestimmungs-/Wahrscheinlichkeitsvorhersageeinheit, die so ausgebildet ist, dass sie das Symbol findet und die Wahrscheinlichkeit für das Symbol berechnet.

**11.** Medium umfassend einen computerlesbaren Kode, der dazu ausgebildet ist, dass er alle Schritte eines Verfahrens nach einem der Ansprüche 1 bis 8 implementiert.

**Revendications**

**1.** Procédé de décodage arithmétique de données évolutives destiné à décoder un symbole codé arithmétique évolutif, sachant que le procédé comprend :

le décodage arithmétique d'un symbole souhaité à l'aide du symbole et d'une probabilité pour le symbole ; et
la décision de continuer ou non un décodage du symbole ;

moyennant quoi, lors de la décision de continuer ou non le décodage, le procédé comprend :

le décodage à l'aide des bits de remplissage afin de décoder le train de bits restant après troncature si un train de bits valide demeure ;
la poursuite du décodage si le symbole est décodé sans ambiguïté quels que soient les bits de remplissage ; et
le fait de mettre fin au décodage si le symbole est décodé sur la base des bits de remplissage et si on détermine que l'ambiguïté se produit.

2. Procédé selon la revendication 1, dans lequel la décision de continuer ou non le décodage comprend :

le calcul de K, K étant une valeur de côté droit d'une équation suivants :

$$v2 < \frac{(haut - bas + 1) \cdot fréq - v1 + bas - 1}{2^{14}}$$

$$v2 \geq \frac{(haut - bas + 1) \cdot fréq - v1 + bas - 1}{2^{14}}$$

la décision, selon une valeur de K, de continuer ou non le décodage, où dans ces équations, v1 désigne une valeur du train de bits valide restant après troncature, v2 désigne une valeur du train de bits tronqué après la troncature, remplissage désigne un nombre de bits v2, fréq désigne la valeur de probabilité pour le symbole, haut et bas désignent respectivement une limite supérieure et une limite inférieure d'une plage dans laquelle existe la valeur de probabilité ;
le décodage du symbole comme étant 1 si K est égale ou supérieure à $2^{remplissage}$-1, et le décodage du symbole comme étant 0 si K est égale ou inférieure à 0 ; et
le fait de déterminer que l'ambiguïté se produit, si K est comprise entre 0 et $2^{remplissage}$-1, et l'arrêt, par conséquent, du décodage.

3. Procédé selon la revendication 2, avant le décodage arithmétique du symbole, comprenant en outre :

la découverte du symbole ; et
le calcul de la probabilité pour le symbole.

4. Procédé selon la revendication 3, dans lequel le calcul de la probabilité pour le symbole comprend :

la découverte d'un mode de décodage à partie des informations d'en-tête d'un train de bits à décoder ; et
l'obtention de la probabilité pour le symbole en se référant à un contexte du symbole si le mode de décodage est un mode de codage arithmétique basé sur le contexte (cbac).

5. Procédé selon la revendication 4, dans lequel, lors du décodage arithmétique du symbole, si un premier échantillon non nul sur un plan binaire est décodé, un bit de signe correspondant à l'échantillon est décodé de façon arithmétique, et
lorsqu'on détermine que l'ambiguïté se produit, si K est comprise entre 0 et $2^{remplissage}$-1, l'ambiguïté est déterminée comme s'étant produite, et le décodage prend fin en fixant un échantillon, décodé juste avant l'ambiguïté, à 0.

6. Procédé selon la revendication 3, dans lequel le calcul de la probabilité pour le symbole comprend :

la découverte d'un mode de décodage à partir des informations de l'en-tête d'un train de bits à décoder ; et
si le mode de décodage est un mode de Golomb de plan binaire (bpgc), l'obtention de la probabilité pour le symbole, en supposant que les données à décoder aient une distribution Laplacienne.

7. Procédé selon la revendication 3, dans lequel, lors du décodage arithmétique du symbole, si un premier échantillon non nul sur un plan binaire est décodé, un bit de signe correspondant à l'échantillon est décodé de façon arithmétique, et

dans lequel, lorsqu'on détermine que l'ambiguïté se produit, si K est comprise entre 0 et $2^{remplissage}$-1, l'ambiguïté est déterminée comme s'étant produite, et le décodage prend fin en fixant un échantillon, décodé juste avant l'ambiguïté, à 0.

8. Procédé selon la revendication 3, dans lequel le calcul de la probabilité pour le symbole comprend :

la découverte d'un mode de décodage à partir des informations de l'en-tête d'un train de bits à décoder ; et si le mode décodage est un mode basse énergie, l'obtention de la probabilité pour le symbole à l'aide des informations de modèle de probabilité de l'en-tête du train de bits.

9. Appareil de décodage arithmétique de données évolutives pour décoder un symbole codé arithmétique évolutif, sachant que l'appareil comprend :

une unité de décodage de symbole agencée pour décoder de façon arithmétique un symbole souhaité à l'aide du symbole et d'une probabilité pour le symbole ; et
une unité de vérification d'ambiguïté agencée pour déterminer s'il faut continuer un décodage en vérifiant une ambiguïté, l'unité de vérification d'ambiguïté comprenant une unité de détermination de poursuite du décodage pour calculer K, en supposant que K soit une valeur de côté droit d'une équation suivante, et selon une valeur de K, pour décider de la poursuite du décodage :

$$v2 < \frac{(haut - bas + 1) \cdot fréq - v1 + bas - 1}{2^{14}}$$

$$v2 \geq \frac{(haut - bas + 1) \cdot fréq - v1 + bas - 1}{2^{14}}$$

v1 désignant une valeur d'un train de bits valide restant après troncature, v2 désignant une valeur d'un train de bits tronqué après la troncature, remplissage désignant un nombre de bits v2, fréq désignant la valeur de probabilité pour le symbole, haut et bas désignant respectivement une limite supérieure et une limite inférieure d'une plage dans laquelle existe la valeur de probabilité ;
une unité de décodage supplémentaire agencée pour décoder le symbole comme étant 1 si K est égale ou supérieure à $2^{remplissage}$-1, et pour décoder le symbole comme étant 0 si K est égale ou inférieure à 0 ; et
une unité d'arrêt de décodage agencée pour déterminer que l'ambiguïté se produit si K est comprise entre 0 et $2^{remplissage}$-1, et pour mettre fin, par conséquent, au décodage.

10. Appareil selon la revendication 9, comprenant en outre une unité de prédiction de probabilité/détermination de symbole agencée pour découvrir le symbole et pour calculer la probabilité du symbole.

11. Support comprenant un code lisible par ordinateur adapté pour mettre en oeuvre toutes les étapes de l'un quelconque des procédés des revendications 1 à 8.

# FIG. 1 (PRIOR ART)

```
        ( START )
            │
            ▼
┌──────────────────────────┐
│  PERFORM INITIALIZATION   │──── 100
└──────────────────────────┘
            │
            ▼
┌──────────────────────────┐
│  FIND SYMBOL TO BE DECODED │──── 110
└──────────────────────────┘
            │
            ▼
┌──────────────────────────┐
│ CALCULATE SYMBOL PROBABILITY │──── 120
└──────────────────────────┘
            │
            ▼
┌──────────────────────────┐
│ PERFORM ARITHMETIC DECODING │──── 130
└──────────────────────────┘
            │
            ▼
   NO    ◇ END OF BITSTREAM? ◇──── 140
            │ YES
            ▼
        ( END )
```

# FIG. 2 (PRIOR ART)

| HEADER | ARITHMETIC CODED BITSTREAM |
|--------|----------------------------|

TRUNCATE AT
GIVEN TARGET BITRATE

| HEADER | ARITHMETIC CODED BITSTREAM |
|--------|----------------------------|

# FIG. 3 (PRIOR ART)

```
int ac_decode_symbol (ac_coder *ac, int freq)
{
  long range;
  long cum;
  int sym;
  int i;

  range = (long)(ac->high-ac->low)+1;
  cum = ((long)((ac->value-ac->low)+1)<<PRE_SHT);
  if (cum<(range)*freq+1)
  {
 sym = 1;
  ac->high = ac->low + (range*freq>>PRE_SHT)-1;
  }
  else
  {
 sym = 0;
    ac->low = ac->low + (range*freq>>PRE_SHT);
  }

  for (;;) {
    if (ac->high<HALF_VALUE) {
    /* do nothing */
    } else if (ac->low>=HALF_VALUE) {
      ac->value -= HALF_VALUE;
      ac->low -= HALF_VALUE;
      ac->high -= HALF_VALUE;
    } else if (ac->low>=QTR_VALUE && ac->high<TRDQTR_VALUE) {
      ac->value -= QTR_VALUE;
      ac->low -= QTR_VALUE;
      ac->high -= QTR_VALUE;
    } else
      break;
    ac->low = 2*ac->low;
    ac->high = 2*ac->high+1;
    ac->value = 2*ac->value + input_bit(ac);
  }

  return sym;
}
```

# FIG. 4

V1          V2

| 1 | 1 | 0 | 0 | 0 | 1 | 0 | 1 | 0 | 1 | 1 | 0 | 0 | X | X | X |

TRUNCATED
BUFFER INDEX

DECODING
BUFFER INDEX

# FIG. 5

| 500 | 520 | 540 |
| SYMBOL DETERMINATION /PROBABILITY PREDICTION UNIT | SYMBOL DECODING UNIT | AMBIGUITY CHECKING UNIT |

# FIG. 6

540

| 600 | 620 |
| DECODING CONTINUATION DETERMINATION UNIT | ADDITIONAL DECODING UNIT |

640

DECODING TERMINATION UNIT

# FIG. 7

START

DETERMINE SYMBOL TO
BE ARITHMETIC DECODED — 700

PREDICT PROBABILITY
OF SYMBOL — 710

ARITHMETIC DECODE
WITH SYMBOL AND
PREDICTED PROBABILITY — 720

730
$0 < K < 2^{dummy} - 1$ ?

NO

750
$K < 0$ ?

NO

YES 740

DETERMINE OCCURRENCE
OF AMBIGUITY AND
TERMINATE DECODING

YES 760
Sym = 0

770
Sym = 1

END

# FIG. 8

ORIGINAL SAMPLES

MSB

| 0 | 0 | 0 | 1 | 0 | 0 | 0 | 0 | 0 |
|---|---|---|---|---|---|---|---|---|
| 1 | 1 | 0 | 0 | 0 | 0 | 1 | 0 | 0 |
| 1 | 0 | 0 | 0 | 0 | 0 | 0 | 0 | 1 |
| 0 | 0 | 0 | 0 | 0 | 1 | 1 | 0 | 1 |
| 0 | 0 | 0 | 1 | 0 | 1 | 1 | 1 | 0 |
| 0 | 0 | 1 | 1 | 1 | 1 | 0 | 0 | 0 |
| 0 | 0 | 1 | 1 | 0 | 0 | 0 | 0 | 1 |

LSB

48 32 3 71 2 14 44 4 25

DECODING RESULT OF
CONVENTIONAL METHOD

MSB

| 0 | 0 | 0 | 1 | 0 | 0 | 0 | 0 | 0 |
|---|---|---|---|---|---|---|---|---|
| 1 | 1 | 0 | 0 | 0 | 0 | 1 | 0 | 0 |
| 1 | 0 | 0 | 0 | 0 | 0 | 0 | 0 | 1 |
| 0 | X | X | X | X | X | X | X | X |
| X | X | X | X | X | X | X | X | X |
| X | X | X | X | X | X | X | X | X |
| X | X | X | X | X | X | X | X | X |

LSB

48 32 0 64 0 0 32 0 16

DECODING RESULT OF METHOD OF
PRESENT INVENTION

MSB

| 0 | 0 | 0 | 1 | 0 | 0 | 0 | 0 | 0 |
|---|---|---|---|---|---|---|---|---|
| 1 | 1 | 0 | 0 | 0 | 0 | 1 | 0 | 0 |
| 1 | 0 | 0 | 0 | 0 | 0 | 0 | 0 | 1 |
| 0 | 0 | 0 | 0 | 0 | 1 | 1 | X | X |
| X | X | X | X | X | X | X | X | X |
| X | X | X | X | X | X | X | X | X |
| X | X | X | X | X | X | X | X | X |

LSB

48 32 0 64 0 8 40 0 16

ADDITIONALLY
DECODED
SYMBOLS

## FIG. 9

< ORIGINAL SAMPLES >

SIGN | 1 | 1 | −1 | 1 | −1 | −1 | 1 | −1 |

| MSB | 0 | 1 | 0 | 0 | 0 | 0 | 0 | 0 |
|-----|---|---|---|---|---|---|---|---|
|     | 0 | 0 | 0 | 1 | 0 | 0 | 0 | 0 |
|     | 0 | 0 | 0 | 0 | 1 | 0 | 1 | 0 |
|     | 1 | 0 | 1 | 1 | 0 | 1 | 0 | 0 |
|     | 1 | 1 | 1 | 1 | 0 | 1 | 1 | 1 |
|     | 1 | 0 | 1 | 1 | 0 | 1 | 1 | 1 |
| LSB | 0 | 0 | 0 | 1 | 0 | 0 | 0 | 1 |
|     | 0 | 1 | 1 | 0 | 0 | 1 | 1 | 0 |

28 137 29 94 32 29 45 14

OCCURRENCE OF
DECODING ERROR

SETTING SAMPLES
ENCODED BEFORE
SIGN BIT, TO 0

< SAMPLE DECODED FROM TRUNCATED BITSTREAM >

SIGN | x | 1 | x | 1 | x | x | x | x |

| MSB | 0 | 1 | 0 | 0 | 0 | 0 | 0 | 0 |
|-----|---|---|---|---|---|---|---|---|
|     | 0 | 0 | 0 | 1 | 0 | 0 | 0 | 0 |
|     | 0 | 0 | 0 | 0 | 1 | x | x | x |
|     | x | x | x | x | x | x | x | x |
|     | x | x | x | x | x | x | x | x |
|     | x | x | x | x | x | x | x | x |
| LSB | x | x | x | x | x | x | x | x |
|     | x | x | x | x | x | x | x | x |

0 128 0 64 32 0 0 0

⟹

SIGN | x | 1 | x | 1 | ? | x | x | x |

| MSB | 0 | 1 | 0 | 0 | 0 | 0 | 0 | 0 |
|-----|---|---|---|---|---|---|---|---|
|     | 0 | 0 | 0 | 1 | 0 | 0 | 0 | 0 |
|     | 0 | 0 | 0 | 0 | 1 | x | x | x |
|     | x | x | x | x | x | x | x | x |
|     | x | x | x | x | x | x | x | x |
|     | x | x | x | x | x | x | x | x |
| LSB | x | x | x | x | x | x | x | x |
|     | x | x | x | x | x | x | x | x |

0 128 0 64 32 0 0 0

⟹

SIGN | x | 1 | x | 1 | x | x | x | x |

| MSB | 0 | 1 | 0 | 0 | 0 | 0 | 0 | 0 |
|-----|---|---|---|---|---|---|---|---|
|     | 0 | 0 | 0 | 1 | 0 | 0 | 0 | 0 |
|     | 0 | 0 | 0 | 0 | 0 | x | x | x |
|     | x | x | x | x | x | x | x | x |
|     | x | x | x | x | x | x | x | x |
|     | x | x | x | x | x | x | x | x |
| LSB | x | x | x | x | x | x | x | x |
|     | x | x | x | x | x | x | x | x |

0 128 0 64 32 0 0 0

EP 1 681 671 B1

# FIG. 10

```
        ( START )
            │
            ▼
┌──────────────────────────┐
│  INTERPRET BITSTREAM LENGTH │ ─── 1000
│   FROM HEADER INFORMATION  │
└──────────────────────────┘
            │
            ▼
┌──────────────────────────┐
│      READ BITSTREAM        │ ─── 1010
└──────────────────────────┘
            │
            ▼
┌──────────────────────────┐
│ CALCULATE BYTES CORRESPONDING │ ─── 1020
│     TO TARGET BITRATE      │
└──────────────────────────┘
            │
            ▼
┌──────────────────────────┐
│   DETERMINE SMALLER VALUE  │
│  BETWEEN CALCULATED TARGET │ ─── 1030
│   BYTES AND ACTUAL NUMBER  │
│  OF BITS, AS BITSTREAM LENGTH │
└──────────────────────────┘
            │
            ▼
┌──────────────────────────┐
│     STORE AND TRANSMIT     │ ─── 1040
│  BITSTREAM OF TARGET LEGNTH │
└──────────────────────────┘
            │
            ▼
         ( END )
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2280816 A